# FASCICULE DE BREVET EUROPEEN

(11) **EP 3 648 165 B1**
(45) Date de publication et mention de la délivrance du brevet: **23.06.2021**
(21) Numéro de dépôt: 19203921.2
(22) Date de dépôt: 17.10.2019
(51) Int. Cl.: H01L 27/15, H01L 33/24

(54) **DISPOSITIF D'AFFICHAGE ÉLECTROLUMINESCENT MULTI-COULEURS ET PROCÉDÉ DE FABRICATION D'UN TEL DISPOSITIF**
VORRICHTUNG ZUR MEHRFARBIGEN ELEKTROLUMINESZENZ-ANZEIGE UND HERSTELLUNGSVERFAHREN EINER SOLCHEN VORRICHTUNG
DEVICE FOR MULTI-COLOUR LIGHT-EMITTING DISPLAY AND METHOD FOR MANUFACTURING SUCH A DEVICE

(30) Priorité: 29.10.2018 FR 1871328
(43) Date de publication de la demande: 06.05.2020
(73) Titulaire: Commissariat à l'Energie Atomique et aux Energies Alternatives, 75015 Paris (FR)
(72) Inventeur: DUSSAIGNE, Amélie, 38054 GRENOBLE CEDEX 9 (FR)
(74) Mandataire: Cabinet Beaumont

(56) Documents cités:
- EP-A2- 2 390 930
- US-A1- 2017 323 925

## Description

### Domaine technique

La présente description concerne de façon générale les dispositifs électroluminescents à base de matériaux semiconducteurs et leurs procédés de fabrication. Elle vise plus particulièrement la réalisation d'un dispositif d'affichage électroluminescent multi-couleurs, c'est-à-dire comportant une pluralité de pixels parmi lesquels des pixels de types différents sont respectivement adaptés à émettre de la lumière dans des gammes de longueurs d'ondes différentes.

### Technique antérieure

Un dispositif d'affichage électroluminescent comprend classiquement une pluralité de pixels, chaque pixel étant commandable individuellement pour convertir un signal électrique en un rayonnement lumineux. Plus particulièrement, chaque pixel comprend une cellule électroluminescente comportant un empilement d'une première couche semiconductrice dopée d'un premier type de conductivité, d'une couche active, et d'une deuxième couche semiconductrice dopée du deuxième type de conductivité. En fonctionnement, un courant électrique est appliqué entre les première et deuxième couches semiconductrices de la cellule. Sous l'effet de ce courant, la couche active émet un rayonnement lumineux dans une gamme de longueurs d'ondes qui dépend essentiellement de sa composition. Chaque pixel peut de plus comprendre un circuit de contrôle, comprenant par exemple un ou plusieurs transistors, permettant de contrôler l'intensité du courant appliqué à la cellule électroluminescente du pixel, et par conséquent l'intensité du rayonnement lumineux émis par le pixel.

Pour permettre l'affichage d'images multi-couleurs, il convient que le dispositif d'affichage comprenne plusieurs pixels de types différents adaptés à émettre respectivement dans des gammes de longueurs d'ondes différentes.

Pour réaliser un dispositif d'affichage multi-couleurs, une possibilité est de reporter sur un même substrat des pixels réalisés séparément à base de matériaux semiconducteurs différents. La fixation et l'alignement des pixels sur le substrat de report peuvent toutefois être délicats à réaliser. En particulier, cette technique n'est pas adaptée à la réalisation de dispositifs d'affichage ayant un pas inter-pixels faible, par exemple inférieur à 10 µm.

Une autre possibilité est de réaliser un dispositif d'affichage dans lequel les cellules électroluminescentes des pixels émettent toutes dans la même gamme de longueurs d'ondes, les cellules électroluminescentes de certains pixels étant revêtues d'une couche de conversion de couleurs, par exemple une couche incorporant des boîtes quantiques ou des nano-phosphores, adaptée à convertir le rayonnement lumineux émis par la cellule électroluminescente en un rayonnement lumineux dans une autre gamme de longueurs d'ondes. Le dépôt localisé de couches de conversion de couleurs peut toutefois être difficile à réaliser, notamment sur des pixels de petites dimensions. De plus, la tenue dans le temps des matériaux de conversion de couleurs est généralement relativement limitée.

Une autre possibilité est de réaliser successivement les cellules électroluminescentes des pixels de types différents, lors de séquences d'épitaxie localisée distinctes, en modifiant à chaque séquence la composition des couches déposées de façon à obtenir des pixels à émission directe dans des gammes de longueurs d'ondes distinctes. Un inconvénient de cette méthode réside toutefois dans son coût élevé, lié à la mise en oeuvre de plusieurs séquences d'épitaxie successives pour réaliser successivement les cellules électroluminescentes des différents types de pixels. Les documents EP2390930 A2 et US2017323925 A1 décrivent des exemples de réalisation de dispositifs d'affichage à LED multi-couleurs.

### Résumé de l'invention

Il existe un besoin pour un dispositif d'affichage électroluminescent multi-couleurs et pour un procédé de fabrication d'un tel dispositif, palliant tout ou partie des inconvénients des solutions connues.

Ainsi, un mode de réalisation prévoit un dispositif électroluminescent comportant des premier, deuxième et troisième pixels adaptés à émettre respectivement dans des première, deuxième et troisième gammes de longueurs d'ondes, dans lequel :
- le premier pixel comprend une cellule électroluminescente bidimensionnelle comprenant un empilement vertical d'une première couche semiconductrice dopée d'un premier type de conductivité, d'une couche active, et d'une deuxième couche semiconductrice dopée du deuxième type de conductivité ;
- chacun des deuxième et troisième pixels comprend une cellule électroluminescente tridimensionnelle comprenant une pluralité de nanostructures de mêmes dimensions régulièrement réparties sur la surface du pixel, chaque nanostructure comportant un coeur semiconducteur pyramidal dopé du premier type de conductivité, une couche active revêtant les parois latérales du coeur, et une couche semiconductrice dopée du deuxième type de conductivité revêtant la couche active ; et
- les nanostructures des deuxième et troisième pixels ont des dimensions différentes et/ou un espacement différent.

Selon un mode de réalisation, dans chacun des premier, deuxième et troisième pixels, la couche active comprend une alternance de couches semiconductrices d'un premier matériau et de couches semiconductrices d'un deuxième matériau définissant des puits quantiques multiples.

Selon un mode de réalisation, dans chacun des premier, deuxième et troisième pixels, le premier matériau est de l'InGaN et le deuxième matériau est du GaN ou de l'InGaN ayant une concentration d'indium inférieure à celle du premier matériau.

Selon un mode de réalisation, la première couche semiconductrice du premier pixel et les coeurs semiconducteurs des deuxième et troisième pixels sont en GaN dopé de type N ou en InGaN dopé de type N.

Selon un mode de réalisation, la deuxième couche semiconductrice du premier pixel et les couches semiconductrices dopées du deuxième type de conductivité des deuxième et troisième pixels sont en GaN dopé de type P ou en InGaN dopé de type P.

Selon un mode de réalisation, le dispositif comporte une couche semiconductrice de base sensiblement plane dont une face est revêtue d'une couche diélectrique de masquage sensiblement plane, la couche de masquage comportant, en regard du premier pixel, une unique ouverture délimitant latéralement la première couche semiconductrice du premier pixel, et, en regard de chacun des deuxième et troisième pixels, une pluralité d'ouvertures délimitant latéralement les coeurs semiconducteurs des deuxième et troisième pixels, la première couche semiconductrice du premier pixel et les coeurs semiconducteurs des deuxième et troisième pixels étant disposés sur et en contact avec ladite face de la couche semiconductrice de base, dans lesdites ouvertures.

Un autre mode de réalisation prévoit un procédé de fabrication d'un dispositif tel que défini ci-dessus, dans lequel la première couche semiconductrice du premier pixel et les coeurs semiconducteurs des deuxième et troisième pixels sont formés simultanément lors d'une même étape d'épitaxie.

Selon un mode de réalisation, la première couche semiconductrice du premier pixel et les coeurs semiconducteurs des deuxième et troisième pixels sont formés par épitaxie localisée sur une face d'une couche semiconductrice de base revêtue d'une couche diélectrique de masquage.

Selon un mode de réalisation, la couche diélectrique de masquage comprend, en regard de chacun des deuxième et troisième pixels, une pluralité d'ouvertures régulièrement réparties sur toute la surface de la cellule électroluminescente du pixel.

Selon un mode de réalisation, les ouvertures sont formées par gravure de la couche diélectrique de masquage en vis-à-vis de pores d'un film de porosité contrôlée réalisé à base de copolymères à blocs.

Selon un mode de réalisation, les couches actives des premier, deuxième et troisième pixels sont formées simultanément lors d'une même étape d'épitaxie.

Selon un mode de réalisation, les conditions de croissance épitaxiale lors de la formation des couches actives des premier, deuxième et troisième pixels sont les suivantes :
- température de croissance de 720°C +/- 30°C ;
- vitesse de croissance de 0,12 µm/h +/- 0,007 µm/h ;
- rapport de flux Indium/Gallium compris entre 2 et 5 ;
- rapport semiconducteurs V/III supérieur à 5000 ; et
- pression de l'ordre de 400 mbar.

Selon un mode de réalisation, la deuxième couche semiconductrice du premier pixel et les couches semiconductrices des deuxième et troisième pixels sont formées simultanément lors d'une même étape d'épitaxie.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue de dessus représentant de façon schématique et partielle une étape d'un procédé de fabrication d'un dispositif d'affichage électroluminescent selon un mode de réalisation ;
la figure 2 est une vue en coupe de la structure de la figure 1 ;
la figure 3 est une vue en coupe représentant de façon schématique et partielle une autre étape d'un procédé de fabrication d'un dispositif d'affichage électroluminescent selon un mode de réalisation ;
la figure 4 est une vue en coupe représentant de façon schématique et partielle une autre étape d'un procédé de fabrication d'un dispositif d'affichage électroluminescent selon un mode de réalisation ;
la figure 5 est une vue en coupe représentant de façon schématique et partielle une autre étape d'un procédé de fabrication d'un dispositif d'affichage électroluminescent selon un mode de réalisation ;
la figure 6 est une vue en coupe représentant de façon schématique et partielle une autre étape d'un procédé de fabrication d'un dispositif d'affichage électroluminescent selon un mode de réalisation ; et
la figure 7 est une vue en coupe représentant de façon schématique et partielle une autre étape d'un procédé de fabrication d'un dispositif d'affichage électroluminescent selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, on s'intéresse ici plus spécifiquement à la réalisation des cellules électroluminescentes des pixels d'un dispositif d'affichage électroluminescent multi-couleurs. La réalisation des circuits de contrôle des pixels et d'éventuelles structures d'isolation entre les cellules électroluminescentes des pixels n'a pas été détaillée, la réalisation de ces éléments étant à la portée de l'homme du métier.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des vues en coupe des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

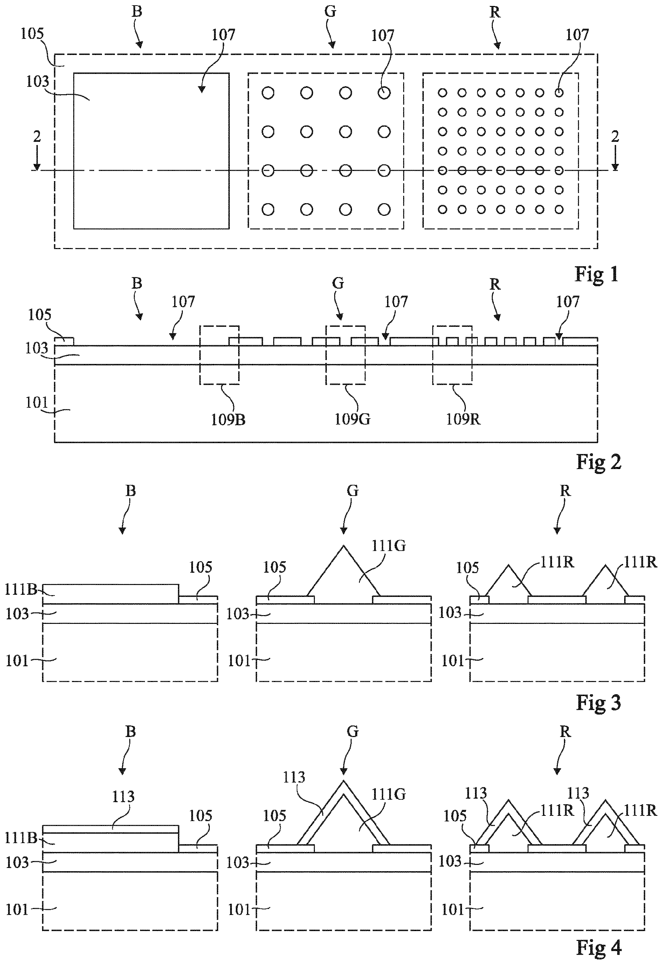

Les figures 1 à 7 représentent des étapes successives d'un exemple d'un procédé de fabrication d'un dispositif d'affichage électroluminescent multi-couleurs selon un mode de réalisation.

On considère ici, à titre d'exemple, la réalisation d'un dispositif d'affichage comportant trois types de pixels différents, adaptés à émettre respectivement dans trois gammes de longueurs d'ondes distinctes. Plus particulièrement, on cherche dans cet exemple à réaliser un dispositif d'affichage comportant un ou plusieurs pixels d'un premier type, appelés pixels bleus, adaptés à émettre majoritairement de la lumière bleue, par exemple dans une gamme de longueurs d'ondes comprise entre 400 et 490 nm, un ou plusieurs pixels d'un deuxième type, appelés pixels verts, adaptés à émettre majoritairement de la lumière verte, par exemple dans une gamme de longueurs d'ondes comprise entre 490 et 570 nm, et un ou plusieurs pixels d'un troisième type, appelés pixels rouges, adaptés à émettre majoritairement de la lumière rouge, par exemple dans une gamme de longueurs d'ondes comprise entre 570 et 710 nm. Sur les figures 1 à 7, un unique pixel bleu B, un unique pixel vert G et un unique pixel rouge R sont représentés, étant entendu que, en pratique, le dispositif d'affichage peut comporter plusieurs pixels de chaque type, les pixels d'un même type étant identiques ou similaires aux dispersions de fabrication près.

Dans cet exemple, dans chaque pixel, la couche active de la cellule électroluminescente du pixel comprend des moyens de confinement correspondant à des puits quantiques multiples. Plus particulièrement, la couche active comprend une alternance de couches semiconductrices d'un premier matériau et de couches semiconductrices d'un deuxième matériau, chaque couche du premier matériau étant prise en sandwich entre deux couches du deuxième matériau, le premier matériau ayant une bande interdite plus étroite que celle du deuxième matériau.

A titre d'exemple, chacun des premier et deuxième matériaux comprend majoritairement un composé III-V comprenant au moins un premier élément du groupe III, un deuxième élément du groupe V, et, éventuellement, un troisième élément, par exemple un élément du groupe III autre que le premier élément.

Des exemples d'éléments du groupe III comprennent le gallium (Ga), l'indium (In) ou l'aluminium (Al). Des exemples d'éléments du groupe V comprennent l'azote, le phosphore ou l'arsenic. Des exemples de composés III-V binaires et ternaires sont le GaN, l'AlN, l'InN, l'InGaN, l'AlGaN ou l'AlInGaN. De façon générale, les éléments dans le composé III-V peuvent être combinés avec différentes fractions molaires.

Dans un mode de réalisation préféré, le premier matériau est de l'InGaN et le deuxième matériau est du GaN ou de l'InGaN ayant une concentration d'indium inférieure à celle du premier matériau.

Selon un aspect d'un mode de réalisation, on prévoit de réaliser simultanément les cellules électroluminescentes des trois types de pixels, lors d'une même séquence d'étapes d'épitaxie.

Pour cela, on joue sur la géométrie des cellules électroluminescentes des différents pixels pour, lors d'une même étape de croissance épitaxiale, obtenir des concentrations d'indium différentes dans les couches actives des pixels de types différents, et ainsi obtenir des longueurs d'ondes d'émission différentes par les cellules électroluminescentes des pixels de types différents.

Plus particulièrement, dans l'exemple décrit en relation avec les figures 1 à 7, les cellules électroluminescentes des pixels bleus B du dispositif sont des cellules bidimensionnelles, constituées chacune d'un empilement de couches semiconductrices sensiblement planes s'étendant de façon continue sur toute la surface de la cellule. Les cellules électroluminescentes des pixels verts G et rouges R du dispositif sont quant à elles des cellules tridimensionnelles, comprenant chacune une pluralité de nanostructures pyramidales identiques ou similaires, régulièrement réparties sur la surface de la cellule, chaque nanostructure comportant un coeur semiconducteur en forme de pyramide, la couche active de la cellule étant formée sur les faces latérales du coeur semiconducteur de chaque nanostructure. Dans cet exemple, les cellules électroluminescentes des pixels verts diffèrent des cellules électroluminescentes des pixels rouges essentiellement par les dimensions et/ou l'espacement de leurs nanostructures pyramidales respectives. Plus particulièrement, dans cet exemple, les nanostructures pyramidales des pixels rouges ont des dimensions inférieures à celles des nanostructures pyramidales des pixels verts, et le pas inter-pyramides, c'est-à-dire la distance centre à centre entre deux nanostructures pyramidales voisines, est plus faible dans les pixels rouges que dans les pixels verts.

Les figures 1 (vue de dessus) et 2 (vue en coupe selon le plan 2-2 de la figure 1) représentent une structure de départ comportant un substrat de croissance 101, par exemple en saphir (Al₂O₃), en carbure de silicium (SiC) ou en silicium (Si), et, sur la face supérieure du substrat 101, une couche de nitrure de gallium (GaN) 103 dopée de type N. La couche 103 est par exemple formée par épitaxie sur la face supérieure du substrat 101. Une couche tampon (non représentée) peut éventuellement faire interface entre la face supérieure du substrat 101 et la couche 103. Dans cet exemple, la couche 103 s'étend de façon continue sur toute la surface du dispositif d'affichage. L'épaisseur de la couche 103 est par exemple sensiblement uniforme sur toute la surface du dispositif.

Les figures 1 et 2 illustrent plus particulièrement une étape de formation d'un masque 105 sur la face supérieure de la couche 103. Le masque 105 est par exemple en un matériau diélectrique, par exemple en nitrure de silicium (par exemple Si₃N₄). Le masque 105 comprend, en regard de chaque pixel du dispositif, une ou plusieurs ouvertures traversantes 107 débouchant sur la face supérieure de la couche 103, définissant la forme de la future cellule électroluminescente du pixel. Plus particulièrement, dans cet exemple, le masque 105 comprend :
- en regard du pixel bleu B, une unique ouverture 107, par exemple de forme carrée ou rectangulaire (en vue de dessus), s'étendant sur sensiblement toute la surface de la future cellule électroluminescente du pixel ;
- en regard du pixel vert G, une pluralité d'ouvertures 107 identiques ou similaires, par exemple de forme circulaire (en vue de dessus), régulièrement réparties sur toute la surface de la future cellule électroluminescente du pixel ; et
- en regard du pixel rouge R, une pluralité d'ouvertures 107 identiques ou similaires, par exemple de forme circulaire (en vue de dessus), régulièrement réparties sur toute la surface de la future cellule électroluminescente du pixel.

A titre d'exemple, les ouvertures 107 formées en vis-à-vis du pixel vert G, respectivement du pixel rouge R, sont, en vue de dessus, agencées en matrice selon des rangées et des colonnes. A titre d'exemple, les cellules électroluminescentes des pixels B, G et R ont, vues de dessus, la même forme générale, par exemple une forme carrée ou rectangulaire, et les mêmes dimensions latérales. Les modes de réalisation décrits ne se limitent toutefois pas à ce cas particulier.

A titre d'exemple, les dimensions latérales de l'ouverture 107 formée en regard du pixel B sont comprises entre 1 et 20 µm, de préférence entre 5 et 10 µm. A titre d'exemple, chacune des ouvertures 107 formées en regard du pixel G a une dimension latérale (largeur ou diamètre) comprise entre 100 et 300 nm, de préférence de l'ordre de 200 nm, et le pas (distance centre à centre) entre ouvertures 107 voisines en regard du pixel G est compris entre 1 et 3 µm, par exemple de l'ordre de 2 µm. A titre d'exemple, chacune des ouvertures 107 formées en regard du pixel R a une dimension latérale comprise entre 10 et 100 nm, de préférence entre 20 et 50 nm, et le pas entre ouvertures 107 voisines en regard du pixel R est compris entre 100 nm et 1 µm, de préférence entre 200 nm et 500 nm. L'épaisseur du masque 105 est par exemple comprise entre 10 et 100 nm, de préférence entre 20 et 40 nm.

Les ouvertures 107 sont par exemple formées par photolithographie, ou encore par lithographie par faisceau d'électrons. Pour définir des ouvertures 107 de très petites dimensions, notamment en regard du pixel R, une solution alternative à la photolithographie ou à la lithographie par faisceau d'électrons consiste à déposer un film de porosité contrôlée à base de copolymères à blocs sur la face supérieure du masque 105, puis à graver le masque 105 en regard des pores du film de copolymères pour former les ouvertures 107. Un exemple de mise en oeuvre d'un tel procédé est par exemple décrit dans l'article intitulé "Density Multiplication and Improved Lithography by Directed Block Copolymer Assembly" de Ricardo Ruiz et al (Science 15 Aug 2008: Vol. 321, Issue 5891, pp. 936-939).

Les figures 3 à 7 illustrent diverses étapes de dépôt postérieures à la formation du masque 105. Par souci de clarté, on a représenté sur ces figures seulement une partie du pixel B, correspondant à un agrandissement de la zone 109B de la figure 2, une partie du pixel G, correspondant à un agrandissement de la zone 109G de la figure 2, et une partie du pixel R, correspondant à un agrandissement de la zone 109R de la figure 2.

La figure 3 illustre une étape de dépôt, par épitaxie, d'un matériau semiconducteur dopé de type N sur la face supérieure de la structure des figures 1 et 2. Lors de cette étape, la croissance épitaxiale s'opère à partir de la face supérieure de la couche 103, au fond des ouvertures 107. Le dépôt est donc localisé en vis-à-vis des ouvertures 107 du masque 105. Le matériau déposé est par exemple du GaN dopé de type N ou de l'InGaN dopé de type N. L'épitaxie est réalisée de manière simultanée dans tous les pixels du dispositif. L'épitaxie est par exemple effectuée par MOCVD (de l'anglais "MetalOrganic Chemical Vapor Déposition" - épitaxie en phase vapeur aux organométalliques).

Dans le pixel B, du fait des dimensions relativement importantes de l'ouverture 107, la croissance est sensiblement uniforme, ce qui conduit à la formation d'une couche 111B sensiblement plane s'étendant sur toute la surface de l'ouverture 107. Dans le pixel G, respectivement dans le pixel R, du fait des dimensions réduites des ouvertures 107, on obtient, en vis-à-vis de chaque ouverture 107, une nanostructure pyramidale 111G, respectivement 111R, correspondant au coeur d'une structure pyramidale élémentaire de la future cellule électroluminescente du pixel. Les structures 111G, 111R ont par exemple la forme de pyramides hexagonales. Dans le cas où la couche 103 est en GaN, la face supérieure de la couche 103 correspond de préférence à la face de polarité gallium de la couche 103, de façon à favoriser une croissance pyramidale en vis-à-vis des ouvertures 107 des pixels G et R.

A titre d'exemple, à l'issue de l'étape de croissance de la figure 3, la couche 111B a une épaisseur comprise entre 10 et 100 nm, et chacune des pyramides 111G et 111R a une hauteur sensiblement égale, par exemple égale à 30 % près, à la largeur de l'ouverture 107 en vis-à-vis de laquelle elle est formée.

La figure 4 illustre une étape de dépôt, par épitaxie, d'une couche 113 d'un matériau semiconducteur dopé de type N sur la face supérieure de la structure de la figure 3. Lors de cette étape, la croissance épitaxiale s'opère à partir de la face supérieure de la couche 111B dans le pixel B, et à partir des faces latérales des pyramides 111G et 111R dans les pixels G et R. Le dépôt est donc localisé en vis-à-vis de la couche 111B et des structures pyramidales 111G, 111R de la structure de la figure 3. L'épitaxie est réalisée de manière simultanée dans tous les pixels du dispositif. L'épitaxie est par exemple réalisée par MOCVD. Le matériau déposé est par exemple du GaN dopé de type N ou de l'InGaN dopé de type N. A titre d'exemple, le matériau déposé est le même que lors de l'étape de la figure 3, mais un arrêt de croissance est prévu entre l'étape de la figure 3 et l'étape de la figure 4. L'épaisseur de la couche 113 déposée lors de cette étape est par exemple sensiblement la même dans tous les pixels du dispositif, par exemple comprise entre 50 et 250 nm, par exemple de l'ordre de 100 nm. La couche 113 forme une couche tampon, et constitue notamment une coquille autour des pyramides 111G, 111R, en vue d'une étape ultérieure de dépôt des couches actives des cellules électroluminescentes des pixels.

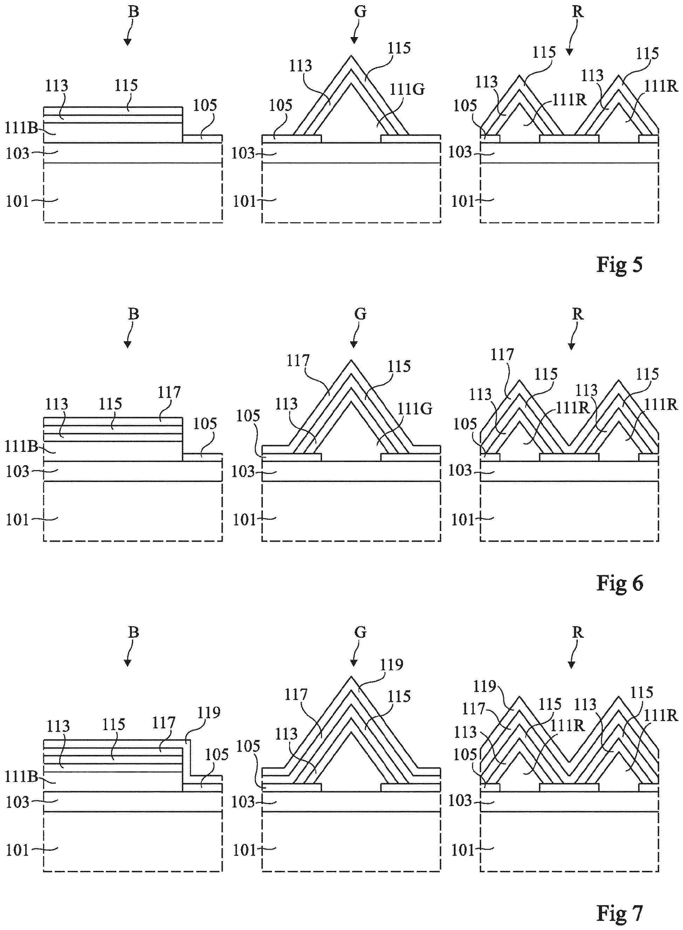

La figure 5 illustre une étape de dépôt, par épitaxie, d'une couche active 115 dans les pixels B, G et R du dispositif. Lors de cette étape, la croissance épitaxiale s'opère à partir de la face supérieure de la couche 113 dans le pixel B, et à partir des faces latérales des coquilles pyramidales formées par la couche 113 dans les pixels G et R. Le dépôt est donc localisé en vis-à-vis de la couche plane 113 dans le pixel B, et en vis-à-vis des coquilles pyramidales formées par la couche 113 dans les pixels G et R. L'épitaxie est réalisée de manière simultanée dans tous les pixels du dispositif. L'épitaxie est par exemple réalisée par MOCVD. Lors de cette étape, on dépose une alternance de couches semiconductrices d'un premier matériau, par exemple de l'InGaN, et de couches semiconductrices d'un deuxième matériau ayant une bande interdite plus large que celle du premier matériau, par exemple du GaN ou de l'InGaN ayant une concentration d'indium inférieure à celle du premier matériau, de façon à former un empilement de puits quantiques, par exemple un empilement de 1 à 10 puits quantiques. A titre d'exemple, l'épaisseur totale de la couche active 115 est comprise entre 10 et 100 nm. Les conditions de croissance épitaxiale de la couche active 115 sont par exemple comme suit :
- température de croissance de 720°C +/- 30°C ;
- vitesse de croissance de 0,12 µm/h +/- 0,007 µm/h ;
- rapport de flux In/Ga compris entre 2 et 5 ;
- rapport V/III supérieur à 5000 et de préférence de 10000 ou plus ;
- pression de l'ordre de 400 mbar ou plus ; et
- épaisseur de puits comprise entre 2 et 3 nm.

L'épaisseur de la couche active 115 est par exemple sensiblement la même dans tous les pixels du dispositif. Toutefois, du fait des différences de géométrie de la surface de croissance entre les pixels B, G et R, la concentration d'indium dans chaque couche d'InGaN de la couche active 115 est différente dans les pixels B, G et R (et ce malgré des conditions d'épitaxie identiques pour l'ensemble des couches actives des pixels B, G et R, puisque réalisées simultanément en une seule étape). On notera en particulier que les pyramides présentent des plans semi-polaires favorables à l'incorporation d'indium. Plus particulièrement, on obtient une concentration d'indium moins importante dans le pixel B que dans le pixel G, et moins importante dans le pixel G que dans le pixel R. Ceci permet d'obtenir des gammes de longueurs d'ondes d'émission différentes dans les pixels B, G et R, et, plus particulièrement, dans cet exemple, une émission majoritairement dans le bleu dans le pixel B, une émission majoritairement dans le vert dans le pixel G, et une émission majoritairement dans le rouge dans le pixel R.

La figure 6 illustre une étape de dépôt, par épitaxie, dans chaque pixel, d'une couche 117 d'un matériau semiconducteur dopé de type P sur la face supérieure de la couche active 115. La couche 117 est déposée de manière simultanée dans tous les pixels du dispositif. La couche 117 s'étend par exemple de façon continue sur toute la surface de la cellule électroluminescente du pixel. La couche 117 est par exemple déposée par MOCVD. La couche active 117 est par exemple déposée sur une épaisseur suffisamment importante pour former, sur chacun des pixels G et R, une couche coalescée s'étendant sur toute la surface de la cellule électroluminescente du pixel. Le matériau déposé est par exemple du GaN dopé de type P ou de l'InGaN dopé de type P. L'épaisseur de la couche 117 est par exemple comprise entre 50 et 250 nm, par exemple de l'ordre de 100 nm.

Bien que non représentée sur les figures, une barrière à électrons peut être déposée entre la couche active 115 et la couche de type P 117. De plus, des espaceurs, par exemple en un matériau semiconducteur non intentionnellement dopé, peuvent être déposés à la base des nanostructures pyramidales des pixels G et R, par exemple entre la couche de type N 113 et la couche active 115, et/ou entre la couche active 115 et la couche de type P 117.

La figure 7 illustre une étape de dépôt, dans chaque pixel, d'une couche conductrice 119 sur et en contact avec la face supérieure de la couche de type P 117. La couche 119 est déposée de manière simultanée dans tous les pixels du dispositif. A titre d'exemple, dans chaque pixel, la couche 119 s'étend de façon continue sur toute la surface de la cellule électroluminescente du pixel. La couche 119 est par exemple déposée par une méthode de dépôt conforme de façon à présenter une épaisseur sensiblement constante sur toute la surface de la cellule électroluminescente. La couche 119 permet notamment, dans chacun des pixels G et R du dispositif, de prendre un contact collectif sur la couche de type P 117 dans toutes les pyramides du pixel. Dans chacun des pixels G et R, un contact collectif peut par ailleurs être pris sur la couche de type N 113 dans toutes les pyramides du pixel, par l'intermédiaire de la couche 103 et des coeurs 111R, 111G. La couche 119 est par exemple en un matériau conducteur transparent, par exemple en oxyde d'indium-étain (ITO). A titre de variante, si le substrat 101 est transparent, le dispositif d'affichage peut être destiné à émettre de la lumière par sa face inférieure, auquel cas la couche 119 peut être réalisée en un matériau conducteur opaque, par exemple un métal, de préférence un métal réfléchissant. Dans une autre variante, dans le cas où le dispositif d'affichage est destiné à émettre de la lumière par sa face supérieure, et dans le cas où la couche de type P 115 est une couche continue s'étendant sur toute la surface du pixel, la couche conductrice 119 peut être réalisée en un matériau conducteur opaque, par exemple un métal, et revêtir une partie seulement de la surface du pixel, par exemple moins de la moitié de la surface du pixel.

On a décrit ci-dessus, en relation avec les figures 1 à 7, un exemple d'un procédé de fabrication d'un ensemble monolithique de cellules électroluminescentes comprenant des cellules de types différents adaptées à émettre de la lumière dans des gammes de longueurs d'ondes différentes.

Pour réaliser un dispositif d'affichage complet, il conviendra de connecter à chaque cellule électroluminescente un circuit de contrôle élémentaire, par exemple à base de transistors MOS, permettant de réguler de façon individuelle le courant circulant dans la cellule, et par conséquent l'intensité lumineuse émise par la cellule. La réalisation de tels circuits de contrôle ne sera pas détaillée ici. A titre d'exemple, on pourra prévoir d'hybrider à une matrice de cellules électroluminescentes réalisée par le procédé des figures 1 à 7, par exemple par collage direct, un circuit intégré formé dans et sur un substrat de silicium, par exemple en technologie CMOS, ce circuit intégré comportant une matrice correspondante de circuits de contrôle élémentaire connectées respectivement aux différentes cellules électroluminescentes.

Un avantage du procédé décrit en relation avec les figures 1 à 7 est qu'il permet de réaliser simultanément, lors d'une même séquence d'étapes d'épitaxie et en utilisant un unique masque 105, au moins trois types de cellules électroluminescentes adaptées à émettre respectivement dans trois bandes de longueurs d'ondes distinctes.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, bien que l'on ait décrit ci-dessus un exemple préférentiel de réalisation permettant de réaliser simultanément trois types de cellules électroluminescentes émettant respectivement dans le bleu, dans le vert et dans le rouge, les modes de réalisation décrits ne se limitent pas à ce cas particulier. En particulier, en jouant sur les dimensions et/ou sur l'espacement des nanostructures pyramidales et/ou sur les compositions des matériaux de la couche active 115, on pourra réaliser des cellules électroluminescentes émettant dans d'autres bandes de longueurs d'ondes que celles mentionnées ci-dessus. De plus, on a décrit ci-dessus un exemple de réalisation comportant une cellule électroluminescente bidimensionnelle (pixel B) et deux cellules électroluminescentes tridimensionnelles distinctes (pixels G et R). A titre de variante, le nombre de cellules électroluminescentes tridimensionnelles distinctes peut être supérieur à 2 de façon à réaliser un dispositif d'affichage comportant au moins quatre types de pixels distincts émettant respectivement dans des bandes de longueurs d'ondes distinctes.

Par ailleurs, pour limiter les contraintes et le risque d'arcure du substrat 101 lors de la mise en oeuvre des différentes étapes de dépôt du procédé décrit ci-dessus, des tranchées (non représentées) délimitant les différents pixels du dispositif peuvent être gravées dans la couche semiconductrice 103, par exemple sur toute la hauteur de la couche 103, avant la formation du masque 105.

Par ailleurs, on notera que tous les types de conductivité des couches semiconductrices décrites ci-dessus peuvent être inversés.

## Revendications

1. Dispositif électroluminescent comportant des premier (B), deuxième (G) et troisième (R) pixels adaptés à émettre respectivement dans des première, deuxième et troisième gammes de longueurs d'ondes, dans lequel :
- le premier pixel (B) comprend une cellule électroluminescente bidimensionnelle comprenant un empilement vertical d'une première couche semiconductrice (111B) dopée d'un premier type de conductivité, d'une couche active (115), et d'une deuxième couche semiconductrice (117) dopée du deuxième type de conductivité ;
- chacun des deuxième (G) et troisième (R) pixels comprend une cellule électroluminescente tridimensionnelle comprenant une pluralité de nanostructures de mêmes dimensions régulièrement réparties sur la surface du pixel, chaque nanostructure comportant un coeur semiconducteur pyramidal (111G, 111R) dopé du premier type de conductivité, une couche active (115) revêtant les parois latérales du coeur, et une couche semiconductrice (117) dopée du deuxième type de conductivité revêtant la couche active ; et
- les nanostructures des deuxième (G) et troisième (R) pixels ont des dimensions différentes et/ou un espacement différent,
le dispositif comportant en outre une couche semiconductrice de base (103) sensiblement plane dont une face est revêtue d'une couche diélectrique de masquage Z (105) sensiblement plane, la couche de masquage comportant, en regard du premier pixel (B), une unique ouverture délimitant latéralement la première couche semiconductrice (111B) du premier pixel (B), et, en regard de chacun des deuxième (G) et troisième (R) pixels, une pluralité d'ouvertures (107) délimitant latéralement les coeurs semiconducteurs (111G, 111R) des deuxième (G) et troisième (R) pixels, la première couche semiconductrice (111B) du premier pixel (B) et les coeurs semiconducteurs (111G, 111R) des deuxième (G) et troisième (R) pixels étant disposés sur et en contact avec ladite face de la couche semiconductrice de base (103), dans lesdites ouvertures (107) .

2. Dispositif selon la revendication 1, dans lequel, dans chacun des premier (B), deuxième (G) et troisième (R) pixels, la couche active (115) comprend une alternance de couches semiconductrices d'un premier matériau et de couches semiconductrices d'un deuxième matériau définissant des puits quantiques multiples.

3. Dispositif selon la revendication 2, dans lequel, dans chacun des premier (B), deuxième (G) et troisième (R) pixels, le premier matériau est de l'InGaN et le deuxième matériau est du GaN ou de l'InGaN ayant une concentration d'indium inférieure à celle du premier matériau.

4. Dispositif selon l'une quelconque des revendications 1 à 3, dans lequel la première couche semiconductrice (111B) du premier pixel (B) et les coeurs semiconducteurs (111G, 111R) des deuxième (G) et troisième (R) pixels sont en GaN dopé de type N ou en InGaN dopé de type N.

5. Dispositif selon l'une quelconque des revendications 1 à 4, dans lequel la deuxième couche semiconductrice (117) du premier pixel (B) et les couches semiconductrices dopées du deuxième type de conductivité des deuxième (G) et troisième (R) pixels sont en GaN dopé de type P ou en InGaN dopé de type P.

6. Procédé de fabrication d'un dispositif selon l'une quelconque des revendications 1 à 5, dans lequel la première couche semiconductrice (111B) du premier pixel (B) et les coeurs semiconducteurs (111G, 111R) des deuxième (G) et troisième (R) pixels sont formés simultanément lors d'une même étape d'épitaxie.

7. Procédé selon la revendication 6, dans lequel la première couche semiconductrice (111B) du premier pixel (B) et les coeurs semiconducteurs (111G, 111R) des deuxième (G) et troisième (R) pixels sont formés par épitaxie localisée sur une face d'une couche semiconductrice de base (103) revêtue d'une couche diélectrique de masquage (105).

8. Procédé selon la revendication 7, dans lequel la couche diélectrique de masquage (105) comprend, en regard de chacun des deuxième (G) et troisième (R) pixels, une pluralité d'ouvertures (107) régulièrement réparties sur toute la surface de la cellule électroluminescente du pixel.

9. Procédé selon la revendication 8, dans lequel les ouvertures (107) sont formées par gravure de la couche diélectrique de masquage (105) en vis-à-vis de pores d'un film de porosité contrôlée réalisé à base de copolymères à blocs.

10. Procédé selon l'une quelconque des revendications 6 à 9, dans lequel les couches actives (115) des premier (B), deuxième (G) et troisième (R) pixels sont formées simultanément lors d'une même étape d'épitaxie.

11. Procédé selon la revendication 10, dans lequel les conditions de croissance épitaxiale lors de la formation des couches actives des premier (B), deuxième (G) et troisième (R) pixels sont les suivantes :
- température de croissance de 720°C +/- 30°C ;
- vitesse de croissance de 0,12 µm/h +/- 0,007 µm/h ;
- rapport de flux Indium/Gallium compris entre 2 et 5 ;
- rapport semiconducteurs V/III supérieur à 5000 ; et
- pression de l'ordre de 400 mbar.

12. Procédé selon l'une quelconque des revendications 6 à 11, dans lequel la deuxième couche semiconductrice (117) du premier pixel (B) et les couches semiconductrices (117) des deuxième (G) et troisième (R) pixels sont formées simultanément lors d'une même étape d'épitaxie.

## Patentansprüche

1. Lichtemittierende Vorrichtung mit einem ersten (B), einem zweiten (G) und einem dritten (R) Pixel, die in der Lage sind, in einem entsprechenden ersten, zweiten und dritten Wellenlängenbereich zu emittieren, wobei:
- das erste Pixel (B) eine zweidimensionale lichtemittierende Zelle aufweist, die einen vertikalen Stapel aus einer ersten dotierten Halbleiterschicht (111B) eines ersten Leitfähigkeitstyps, einer aktiven Schicht (115) und einer zweiten dotierten Halbleiterschicht (117) des zweiten Leitfähigkeitstyps umfasst;
- jedes der zweiten (G) und dritten (R) Pixel eine dreidimensionale lichtemittierende Zelle aufweist, die eine Vielzahl von Nanostrukturen gleicher Abmessungen umfasst, die regelmäßig über die Oberfläche des Pixels verteilt sind, wobei jede Nanostruktur einen dotierten pyramidenförmigen Halbleiterkern (111G, 111R) des ersten Leitfähigkeitstyps, eine aktive Schicht (115), die die Seitenwände des Kerns beschichtet, und eine dotierte Halbleiterschicht (117) des zweiten Leitfähigkeitstyps, die die aktive Schicht beschichtet, umfasst; und
- die Nanostrukturen des zweiten (G) und dritten (R) Pixels unterschiedliche Abmessungen und/oder einen unterschiedlichen Abstand aufweisen,
die Vorrichtung weiterhin eine im Wesentlichen planare Basis-Halbleiterschicht (103) mit einer Oberfläche aufweist, die mit einer im Wesentlichen planaren dielektrischen Maskierungsschicht (105) beschichtet ist, wobei die Maskierungsschicht gegenüber dem ersten Pixel (B) eine einzelne Öffnung aufweist, die die erste Halbleiterschicht (111B) des ersten Pixels (B) lateral begrenzt, und gegenüber jedem der zweiten (G) und dritten (R) Pixel eine Vielzahl von Öffnungen (107) aufweist, die die Halbleiterkerne (111G, 111R) des zweiten (G) und dritten (R) Pixels seitlich begrenzen, wobei die erste Halbleiterschicht (111B) des ersten Pixels (B) und die Halbleiterkerne (111G, 111R) des zweiten (G) und dritten (R) Pixels auf der Oberfläche der Basis-Halbleiterschicht (103) und in Kontakt mit dieser in den Öffnungen (107) angeordnet sind.

2. Vorrichtung nach Anspruch 1, wobei in jedem der ersten (B), zweiten (G) und dritten (R) Pixel die aktive Schicht (115) einen Wechsel von Halbleiterschichten aus einem ersten Material und von Halbleiterschichten aus einem zweiten Material umfasst, die mehrere Quantentöpfe definieren.

3. Vorrichtung nach Anspruch 2, wobei in jedem der ersten (B), zweiten (G) und dritten (R) Pixel das erste Material InGaN ist und das zweite Material GaN oder InGaN mit einer geringeren Indiumkonzentration als die des ersten Materials ist.

4. Vorrichtung nach einem der Ansprüche 1 bis 3, wobei die erste Halbleiterschicht (111B) des ersten Pixels (B) und die Halbleiterkerne (111G, 111R) des zweiten (G) und dritten (R) Pixels aus N-dotiertem GaN oder aus N-dotiertem InGaN hergestellt sind.

5. Vorrichtung nach einem der Ansprüche 1 bis 4, wobei die zweite Halbleiterschicht (117) des ersten Pixels (B) und die dotierten Halbleiterschichten des zweiten Leitfähigkeitstyps des zweiten (G) und dritten (R) Pixels aus P-dotiertem GaN oder aus P-dotiertem InGaN hergestellt sind.

6. Verfahren zur Herstellung der Vorrichtung nach einem der Ansprüche 1 bis 5, wobei die erste Halbleiterschicht (111B) des ersten Pixels (B) und die Halbleiterkerne (111G, 111R) des zweiten (G) und dritten (R) Pixels gleichzeitig während desselben Epitaxieschritts gebildet werden.

7. Verfahren nach Anspruch 6, wobei die erste Halbleiterschicht (111B) des ersten Pixels (B) und die Halbleiterkerne (111G, 111R) des zweiten (G) und dritten (R) Pixels durch lokale Epitaxie auf einer Oberfläche einer Basis-Halbleiterschicht (103) gebildet werden, die mit einer dielektrischen Maskierungsschicht (105) beschichtet ist.

8. Verfahren nach Anspruch 7, wobei die dielektrische Maskierungsschicht (105) gegenüber jedem der zweiten (G) und dritten (R) Pixel eine Vielzahl von Öffnungen (107) aufweist, die regelmäßig über die gesamte Oberfläche der lichtemittierenden Zelle des Pixels verteilt sind.

9. Verfahren nach Anspruch 8, wobei die Öffnungen (107) durch Ätzen der dielektrischen Maskierungsschicht (105) gegenüber von Poren eines Films mit einer kontrollierten Porosität gebildet werden, der auf der Basis von Blockcopolymeren gebildet wird.

10. Verfahren nach einem der Ansprüche 6 bis 9, wobei die aktiven Schichten (115) des ersten (B), zweiten (G) und dritten (R) Pixels gleichzeitig während desselben Epitaxieschritts gebildet werden.

11. Verfahren nach Anspruch 10, wobei die Epitaxiewachstumsbedingungen bei der Bildung der aktiven Schichten des ersten (B), zweiten (G) und dritten (R) Pixels die folgenden sind:
- Wachstumstemperatur von 720°C +/- 30°C;
- Wachstumsgeschwindigkeit von 0,12 µm/h +/- 0,007 µm/h;
- Indium/Gallium-Flussverhältnis zwischen 2 und 5;
- V/III-Halbleiter-Verhältnis größer als 5.000; und
- Druck in der Größenordnung von 400 mbar.

12. Verfahren nach einem der Ansprüche 6 bis 11, wobei die Halbleiterschicht (117) des ersten Pixels (B) und die Halbleiterschichten (117) des zweiten (G) und dritten (R) Pixels gleichzeitig während desselben Epitaxieschritts gebildet werden.

## Claims

1. A light-emitting device comprising first (B), second (G), and third (R) pixels capable of respectively emitting in first, second, and third wavelength ranges, wherein:
- the first pixel (B) comprises a two-dimensional light-emitting cell comprising a vertical stack of a first doped semiconductor layer (111B) of a first conductivity type, of an active layer (115), and of a second doped semiconductor layer (117) of the second conductivity type;
- each of the second (G) and third (R) pixels comprises a three-dimensional light-emitting cell comprising a plurality of nanostructures of same dimensions regularly distributed across the surface of the pixel, each nanostructure comprising a doped pyramidal semiconductor core (111G, 111R) of the first conductivity type, an active layer (115) coating the lateral walls of the core, and a doped semiconductor layer (117) of the second conductivity type coating the active layer; and
- the nanostructures of the second (G) and third (R) pixels have different dimensions and/or a different spacing,
the device further comprising a substantially planar base semiconductor layer (103) having a surface coated with a substantially planar dielectric masking layer (105), the masking layer comprising, opposite the first pixel (B), a single opening laterally delimiting the first semiconductor layer (111B) of the first pixel (B) and, opposite each of the second (G) and third (R) pixels, a plurality of openings (107) laterally delimiting the semiconductor cores (111G, 111R) of the second (G) and third (R) pixels, the first semiconductor layer (111B) of the first pixel (B) and the semiconductor cores (111G, 111R) of the second (G) and third (R) pixels being arranged on top of and in contact with said surface of the base semiconductor layer (103), in said openings (107) .

2. The device of claim 1, wherein, in each of the first (B), second (G), and third (R) pixels, the active layer (115) comprises an alternation of semiconductor layers of a first material and of semiconductor layers of a second material defining multiple quantum wells.

3. The device of claim 2, wherein, in each of the first (B), second (G), and third (R) pixels, the first material is InGaN and the second material is GaN or InGaN having an indium concentration smaller than that of the first material.

4. The device of any of claims 1 to 3, wherein the first semiconductor layer (111B) of the first pixel (B) and the semiconductor cores (111G, 111R) of the second (G) and third (R) pixels are made of N-type doped GaN or of N-type doped InGaN.

5. The device of any of claims 1 to 4, wherein the second semiconductor layer (117) of the first pixel (B) and the doped semiconductor layers of the second conductivity type of the second (G) and third (R) pixels are made of P-type doped GaN or of P-type doped InGaN.

6. A method of manufacturing the device of any of claims 1 to 5, wherein the first semiconductor layer (111B) of the first pixel (B) and the semiconductor cores (111G, 111R) of the second (G) and third (R) pixels are simultaneously formed during a same epitaxy step.

7. The method of claim 6, wherein the first semiconductor layer (111B) of the first pixel (B) and the semiconductor cores (111G, 111R) of the second (G) and third (R) pixels are formed by local epitaxy on a surface of a base semiconductor layer (103) coated with a dielectric masking layer (105).

8. The method of claim 7, wherein the dielectric masking layer (105) comprises, opposite each of the second (G) and third (R) pixels, a plurality of openings (107) regularly distributed across the entire surface of the light-emitting cell of the pixel.

9. The method of claim 8, wherein the openings (107) are formed by etching of the dielectric masking layer (105) opposite pores of a film having a controlled porosity formed based on block copolymers.

10. The method of any of claims 6 to 9, wherein the active layers (115) of the first (B), second (G), and third (R) pixels are formed simultaneously during a same epitaxy step.

11. The method of claim 10, wherein the epitaxial growth conditions on forming of the active layers of the first (B), second (G), and third (R) pixels are the following:
- growth temperature of 720°C +/- 30°C;
- growth speed of 0.12 µm/h +/- 0.007 µm/h;
- Indium/Gallium flow ratio between 2 and 5;
- V/III semiconductor ratio greater than 5,000; and
- pressure in the order of 400 mbar.

12. The method of any of claims 6 to 11, wherein the semiconductor layer (117) of the first pixel (B) and the semiconductor layers (117) of the second (G) and third (R) pixels are simultaneously formed during a same epitaxy step
